# EUROPÄISCHE PATENTANMELDUNG

(11) **EP 2 418 679 A2**
(43) Veröffentlichungstag der Anmeldung: **15.02.2012**
(21) Anmeldenummer: 11169043.4
(22) Anmeldetag: 08.06.2011
(51) Int. Cl.: H01L 23/373, H01L 23/433

(54) **Steuermodul, insbesondere Getriebe- oder Motorsteuermodul für ein Kraftfahrzeug**

(30) Priorität: 10.08.2010 DE 102010039118
(71) Anmelder: Robert Bosch GmbH, 70442 Stuttgart (DE)
(72) Erfinder: Liskow, Uwe, 71679 Asperg (DE)

(57) **Zusammenfassung**

Die Erfindung bezieht sich auf ein Steuermodul (10, 100, 130, 160), insbesondere ein Getriebe- oder Motorsteuermodul für ein Kraftfahrzeug, mit einem eine Vielzahl elektronische und/oder elektrische Bauteile (54, 172) aufweisenden Schaltungsträger (50, 102, 132, 168), wobei dieser allseitig von einem Kunststoffmaterial (56, 116) umgeben ist, das ein Kunststoffgehäuse (12, 106, 136, 162) bildet, und dieses eine Vielzahl von Anschlüssen (48, 118, 120) aufweist, die mit den Bauteilen (54, 172) elektrisch verbunden sind.

Erfindungsgemäß weist das Kunststoffgehäuse (12, 106, 136, 162) zur Wärmeableitung vom Schaltungsträger (50, 102, 132, 168) mindestens einen Wärmeableiter (14) auf, der zumindest bereichsweise von dem Kunststoffmaterial (56) durchsetzt ist und der im Wesentlichen parallel zum Schaltungsträger (50, 102, 132, 168) verläuft.

Dadurch, dass das Kunststoffmaterial (56, 116) den großflächigen Wärmeableiter (14) durchdringt, ergibt sich eine effektive Wärmeüberleitung der von den Bauteilen (54, 172) abgegebenen Verlustwärme in den Wärmeableiter (14). Darüber hinaus erlaubt die Durchsetzung des in mindestens einer Raumrichtung geringfügig "elastischen" Wärmeableiters (14) mit dem gehäusebildenden Kunststoffmaterial (56, 116) einen Ausgleich unterschiedlicher Wärmeausdehnungskoeffizienten des Wärmeableiters (14), des Schaltungsträgers (50, 102, 132, 168) und des Kunststoffgehäuses (12, 106, 136, 162). Hierdurch wird die Rissbildung infolge von temperaturbedingten Materialspannungen verhindert.

## Beschreibung

### Stand der Technik

Steuergeräte verfügen zur Verbesserung der Wärmeabfuhr oftmals über eine unterhalb des Schaltungsträgers angeordnete Wärmeableitplatte. Der Schaltungsträger und die bevorzugt in unmittelbarem Kontakt stehende Wärmeableitplatte werden zusammen in einem Werkzeug vollständig mit einer Kunststoffmasse (=Moldmasse) umspritzt, die neben der Lagefixierung der Komponenten und deren elektrischer Isolation zugleich die hermetisch dichte Einhausung des empfindlichen Schaltungsträgers darstellt. Die Wärmeableitplatte verfügt hierbei über mindestens eine Lasche, die aus dem Kunststoffgehäuse des Mechatronikmoduls herausragt. Zur Abführung der Verlustwärme der auf dem Schaltungsträger befindlichen Bauelemente wird die aus dem Kunststoffgehäuse herausragende Lasche mit einer Wärmesenke, die sich im Idealfall auf einem geringen Temperaturniveau befindet, zum Beispiel einem metallischen Getriebe- oder Motorgehäuse verbunden. Ein Nachteil bei dieser Ausführungsform ist, dass unterschiedliche Wärmeausdehnungskoeffizienten zwischen dem Kunststoffgehäuse, dem Schaltungsträger sowie der Wärmeableitplatte zu einer Rissbildung führen können. Durch diese in vielen Fällen mikroskopisch kleinen Risse können aggressive Umgebungsfluide in das Steuergerät eindringen und aufgrund von Korrosionseffekten zu Funktionsausfällen des Steuergerätes mit weitreichenden Folgeschäden führen.

Aus der EP 1 396 885 A1 ist eine elektronische Steuereinheit für Kraftfahrzeuge bekannt, deren Leiterplatte mit einer elektronischen Steuerschaltung von einem Einkapselungsharz allseitig hermetisch dichtschließend umgeben ist. Unterhalb der Leiterplatte verläuft ein Basiselement (s.g. "Lead-Frame") aus einer Kupferlegierung zur Wärmeabfuhr. Um die unterschiedlichen Wärmeausdehnungskoeffizienten der Leiterplatte, des Kunststoffgehäuses und des Basiselementes auszugleichen, weist die Leiterplatte einen niedrigen Elastizitätsmodul auf. Zudem wird der Wärmeausdehnungskoeffizient des Einkapselungsharzes größer gewählt als der von Leiterplatte und Basiselement, so dass das Kunststoffgehäuse stets eine Kompressionsbeanspruchung auf die Leiterplatte und das Basiselement ausübt.

Ein Nachteil dieser Lösung liegt darin, dass die Komponenten zur Erzielung der Risssicherheit über sehr genau aufeinander abgestimmte physikalische Eigenschaften, insbesondere Elastizitätsmodule und Wärmeausdehnungskoeffizienten, verfügen müssen.

Die DE 10 2007 061 116 A1 betrifft ein Gehäuse für ein Steuergerät, insbesondere für ein Getriebesteuerungsmodul für ein Kraftfahrzeuggetriebe. Diese Module sind hohen Temperaturschwankungen ausgesetzt, die im Fahrbetrieb des Kraftfahrzeugs in einem Bereich zwischen -40 °C und 150 °C liegen können. Um eine ausreichende Wärmeabfuhr für die elektronischen Bauelemente zu gewährleisten, wird die metallische Grundfläche des Steuergerätegehäuses an das Aluminiumgehäuse einer Getriebehydraulik angestellt, das heißt an das Gehäuse mit mechanischem Druck angedrückt. Hierdurch entsteht ein unmittelbar wärmeleitender Kontakt im Bereich der Anlagefläche.

Ein Nachteil dieses Gehäuses liegt darin, dass ein konstruktiv aufwändiges, weil zweiteiliges Metallgehäuse mit einer zusätzlichen Dichtung für die Einhausung des Schaltungsträgers erforderlich ist.

### Offenbarung der Erfindung

Es wird ein Steuermodul, insbesondere ein Getriebe- oder Motorsteuermodul für ein Kraftfahrzeug, offenbart, das einen Schaltungsträger mit einer Vielzahl elektronischer und/oder elektrischer Bauteile aufweist, wobei der Schaltungsträger allseitig von einem Kunststoffmaterial umgeben ist, das ein Kunststoffgehäuse bildet, und das Kunststoffgehäuse eine Vielzahl von Anschlüssen aufweist, die mit den Bauteilen elektrisch verbunden sind.

Erfindungsgemäß verfügt das Kunststoffgehäuse zur Wärmeableitung vom Schaltungsträger über mindestens einen Wärmeableiter, der zumindest bereichsweise von dem Kunststoffmaterial durchsetzt ist und der im Wesentlichen parallel zum Schaltungsträger verläuft.

Dadurch, dass das Kunststoffmaterial des Kunststoffgehäuses den Wärmeableiter im Idealfall vollständig durchsetzt, ergibt sich eine im Vergleich zu den vorbekannten technischen Lösungen vergrößerte Übergangsfläche für die vom Schaltungsträger ausgehende Verlustwärme. Infolge der parallelen Anordnung des Wärmeableiters und des Schaltungsträgers wird der Wärmeübergang zwischen beiden Bauteilen weiter verbessert. Darüber hinaus verhindert die vollständige Durchsetzung des Wärmeableiters mit dem Kunststoffmaterial die Entstehung von thermisch bedingten mechanischen Spannungen zwischen dem Kunststoffgehäuse, dem Schaltungsträger sowie dem Wärmeableiter. Hierdurch wird die Gefahr einer Rissbildung, insbesondere bei starken Temperaturschwankungen, zwischen den genannten Komponenten erheblich reduziert. Der Schaltungsträger kann zum Beispiel mit einem LTCC-Hybrid-Aufbau (="Low-Temperature-Cofired-Ceramic") oder einer Epoxidharz-Leiterplatte, die mit einer Vielzahl unterschiedlichster elektronsicher oder elektrischer Komponenten bestückt sind, realisiert sein. Bei der Fertigung des Steuermoduls wird ein Schaltungsträger zusammen mit dem Wärmeableiter in ein entsprechend ausgestaltetes Formwerkzeug eingelegt. Zur hermetischen Kapselung des Schaltungsträgers und des Wärmeableiters wird in einem abschließenden Fertigungsschritt ein geeignetes Kunststoffmaterial unter Druck in das Formwerkzeug eingespritzt. Hierbei durchsetzt das Kunststoffmaterial die Vielzahl der im Wärmeableiter befindlichen Ausnehmungen bzw. Durchbrechungen. Es können sowohl thermoplastische als auch duroplastische Kunststoffe zur Anwendung kommen.

Der Wärmeableiter ist bevorzugt als ein Flächengebilde, zum Beispiel als ein Geflecht, ausgeführt, das mit einer Vielzahl insbesondere metallischer Drähte aufgebaut ist.

Hierbei kommen bei einem als Geflecht beispielsweise ausgebildeten Flächengebilde bevorzugt dünne und hochflexible Drähte und/oder Folienstreifen aus Kupfer-, Aluminium- oder Stahllegierungen zum Einsatz, die über ein gutes Wärmeleitvermögen verfügen. Gegebenenfalls können die Drähte einzeln und/oder insgesamt isoliert sein, um elektrische Kurzschlüsse zu verhindern. Die elektrische Isolation kann beispielsweise durch Drahtlack und/oder eine Kunststoffummantelung erfolgen. Alternativ können auch Metall-Kunststoff-Verbundwerkstoffe unter Verwendung der erwähnten Metalllegierungen sowie geeignete Matrixkunststoffe zum Einsatz kommen, wenn deren Wärmeleitfähigkeit ausreichend hoch ist.

Die Drähte verlaufen innerhalb des Kunststoffgehäuses des Steuermoduls im Wesentlichen parallel zueinander, wobei ein Abstand zwischen den einzelnen Drähten zwischen 0 mm und mehreren Millimetern variieren kann. Die Drähte sind in einer Längsrichtung des Steuermoduls wellenförmig ausgestaltet. Hierdurch können in der Längsrichtung durch Temperaturschwankungen hervorgerufene mechanische Dehnungsbewegungen des Kunststoffgehäuses und/oder des Schaltungsträgers nicht zu mechanischen Spannungen zwischen diesen und dem Wärmeableiter führen, so dass eine Rissbildung weitgehend ausgeschlossen ist. Da zwischen den einzelnen Drähten eines Geflechtes in der Regel ein Abstand von mehr als 0 mm besteht, können auch in der Querrichtung keine temperaturbedingten mechanischen Spannungen zwischen dem einhüllenden Kunststoffgehäuse, dem Schaltungsträger und dem Wärmeableiter entstehen.

Alternativ kann das Flächengebilde auch durch das Stanzen von Ausnehmungen in eine kompakte Metallfolie bzw. eine dünne Metallplatte hergestellt werden. Weiterhin ist es möglich, das Flächengebilde durch Urformen, zum Beispiel im Wege des Metall-Spritzgusses zu fertigen. Bei der Herstellung des Flächengebildes durch Ausstanzen bzw. durch Spritzgussverfahren kann ein abschließendes Recken des Flächengebildes erfolgen, um den Ausnehmungen im Flächengebilde eine definierte geometrische Form zu verleihen.

Alternativ kann der Wärmeableiter als ein strangförmiges Gebilde ausgeführt sein, das ebenfalls mit einer Vielzahl insbesondere metallischer Drähte aufgebaut ist.

Die einzelnen Drähte können hierbei parallel zueinander verlaufen. Alternativ ist es möglich, die Drähte einzeln oder in Gruppen miteinander zu verseilen, zu verflechten und/oder zu verzwirnen, um den Zusammenhalt der Drähte zu erhöhen.

Das Flächengebilde verfügt über eine im Wesentlichen innerhalb des Kunststoffgehäuses befindliche Auffächerungszone und mindestens eine sich daran anschließende Kompaktierungszone zur wärmeleitenden Anbindung des Wärmeableiters an eine Wärmesenke, wobei die Kompaktierungszone im Wesentlichen außerhalb des Kunststoffgehäuses des Steuermoduls verläuft.

Hierdurch wird die Abwärme innerhalb des Steuermoduls großflächig von der Auffächerungszone des Wärmeableiters aufgenommen und anschließend über die mindestens eine Kompaktierungszone nach außen an eine geeignete Wärmesenke, wie zum Beispiel ein Getriebegehäuse, ein Motorgehäuse oder eine Leiterplatte geführt. Die Kompaktierungszone des wärmeableitenden Flächengebildes besteht aus einer Vielzahl von parallel zueinander verlaufenden Drähten, die zu einer vorzugsweise kreisförmigen Querschnittsgeometrie zusammengepresst sind. Alternativ kann auch eine eckige Querschnittsgeometrie gewählt werden. Im Bereich der Auffächerungszone verlaufen die Drähte gleichfalls parallel zueinander, sind jedoch auseinander gezogen und verlaufen beabstandet zueinander, um das Durchsetzen des Flächengebildes mit dem Kunststoffmaterial zu erlauben und zugleich eine große Wärmeübergangsfläche zu schaffen.

### Kurze Beschreibung der Zeichnungen

Anhand der Zeichnung soll die Erfindung nachstehend eingehender beschrieben werden.

Es zeigt:
- Figur 1: eine Draufsicht auf ein erfindungsgemäßes Steuermodul mit einem integrierten Flächengebilde als Wärmeableiter,
- Figur 2: eine Querschnittsdarstellung des Steuermoduls aus der Figur 1 entlang der Schnittlinie II-II,
- Figur 3: eine Draufsicht auf das Flächengebilde nach Figur 2 mit zwei Presshülsen und einer Endhülse,
- Figur 4: eine Seitenansicht des an einer Wärmesenke befestigten Steuermoduls,
- Figur 5: eine detaillierte Querschnittsdarstellung durch das Steuermodul,
- Figur 6: eine Draufsicht auf eine übergeordnete Funktionseinheit mit dem Steuermodul und weiteren Komponenten,
- Figur 7: eine Seitenansicht der übergeordneten Funktionseinheit gem. Figur 6,
- Figur 8: eine Ausführungsform eines Steuermoduls mit einem innenliegenden Stranggebilde als Wärmeableiter,
- Figur 9: eine Ausführungsform des Steuermoduls mit einem nach außen geführten Stranggebilde als Wärmeableiter,
- Figur 10: eine Ausführungsform eines Steuermoduls mit einem dreidimensional vorgeformten Flächengebilde als Wärmeableiter,
- Figur 11: eine prinzipielle Darstellung des Herstellungsablaufs des Steuermoduls nach Figur 10.
- Figur 12: eine vergrößerte Ausschnittdarstellung des vorgeformten Flächengebildes nach Figur 10,
- Figur 13-15: drei Varianten einer thermischen Anbindung des Steuermoduls nach Maßgabe der Figuren 11 und 12 an eine massive Wärmesenke.

### Ausführungsformen

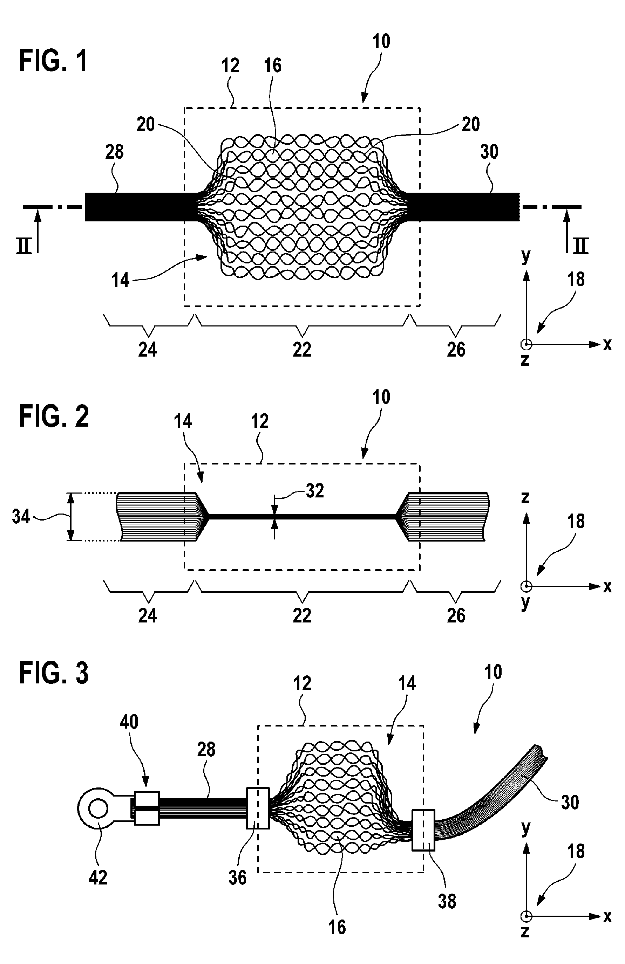

Die Figur 1 zeigt eine schematische Draufsicht auf ein Steuermodul, in das ein mit einer Vielzahl von Drähten gebildetes Flächengebilde als Wärmeableiter integriert ist. Ein Koordinatensystem dient zur Veranschaulichung der räumlichen Lage der einzelnen Komponenten.

Ein Steuermodul 10 verfügt über ein bevorzugt im s.g. "Molding"-Verfahren hergestelltes Kunststoffgehäuse 12, in das ein Wärmeableiter 14 integriert ist, der hier als ein Flächengebilde 16 ausgeführt ist, das auch als Geflecht bezeichnet werden kann. Unterhalb oder oberhalb des Flächengebildes 16, parallel zur xy-Ebene des Koordinatensystems 18, ist ein nicht dargestellter Schaltungsträger angeordnet, der mit einer Vielzahl von elektronischen und elektrischen Komponenten bestückt ist. Um einen möglichst wirksamen Wärmeübergang zwischen dem Schaltungsträger bzw. den darauf befindlichen Bauteilen und dem Wärmeableiter 14 zu erreichen, ist dieser in einem möglichst geringen Abstand zum Schaltungsträger angeordnet. Durch den Wärmeableiter 14 wird die im Bereich des Schaltungsträgers entstehende Verlustwärme der elektronischen und elektrischen Komponenten aus dem Kunststoffgehäuse 12 nach außen hin abgeführt.

Das Flächengebilde 16 ist mit einer Vielzahl von im Wesentlichen parallel zueinander verlaufenden, in sich gewellten Drähten 20 aufgebaut. Die Drähte 20 sind mit einem hinreichend wärmeleitfähigen Material, wie zum Beispiel einer Kupfer-, Aluminium- oder Stahllegierung hergestellt. Zur Verhinderung von elektrischen Kurzschlüssen können die Drähte zumindest abschnittsweise mit einer elektrischen Isolation versehen sein. Alternativ können die Drähte 20 zum Beispiel mit einem Metall-Kunststoff-Verbundmaterial hergestellt sein, sofern eine ausreichende Wärmeleitfähigkeit gegeben ist. Beispielsweise können die Drähte 20 mit wärmeleitfähigen Nanopartikeln gebildet sein, die in eine strangförmige Kunststoffmatrix eingebettet sind. Reicht die Wärmeleitfähigkeit eines Kunststoffmaterials zur Wärmeabfuhr aus, können die Drähte des Flächengebildes 16 vollständig aus einem Kunststoffmaterial bestehen. Als geeignete Kunststoffmaterialien kommen sowohl thermoplastische als auch duroplastische Kunststoffe in Betracht.

Das Flächengebilde 16 verfügt im gezeigten Ausführungsbeispiel über eine rechteckförmige Auffächerungszone 22 sowie zwei sich hieran beidseitig anschließende, strangförmige Kompaktierungszonen 24, 26. Im Bereich der Auffächerungszone 22 sind die Drähte 20 weit auseinander gezogen und weisen jeweils einen wellenförmigen, näherungsweise sinusförmigen, Verlauf auf. Hierdurch bildet sich eine Vielzahl von nicht bezeichneten Ausnehmungen im Flächengebilde 16, die während des Herstellungsprozesses des Kunststoffgehäuses 12 vom Kunststoffmaterial durchsetzt werden können. Die ondulierten Drähte 20 verlaufen in etwa jeweils parallel beabstandet zueinander. Es können jedoch auch mehrere Drähte gruppiert, das heißt zu einem Bündel zusammengefasst sein. Im Bereich der beiden Kompaktierungszonen 24,26 sind die Drähte 20 hingegen kompaktiert, das heißt jeweils zu einem strangförmigen bzw. kabelartigen Anschlussbündel 28, 30 zusammengefasst, die jeweils über eine kreisförmige oder eckige Querschnittsgeometrie verfügen. Die flexiblen Anschlussbündel 28, 30 erleichtern die wärmetechnische Anbindung des Wärmeableiters 14 an eine hier nicht dargestellte Wärmesenke zur Wärmeabfuhr aus dem Steuermodul 10. Die Anschlussbündel 28, 30 können gegebenenfalls über nicht bezeichnete abschnittsweise Verdickungsbereiche verfügen, die zudem in Relation zu den Längsachsen der Anschlussbündel 28, 30 zueinander verdreht bzw. versetzt eingebracht sein können.

Aufgrund der im Bereich der Auffächerungszone 22 weit auseinander gezogen verlaufenden Drähte 20 wird das Flächengebilde 16 vollständig vom Kunststoffmaterial des Kunststoffgehäuses 12 durchsetzt und weist in diesem Bereich eine große Oberfläche auf. Hierbei ist die Auffächerungszone 22 im Wesentlichen eben ausgestaltet. Durch die große Oberfläche der Auffächerungszone 22 ist ein schneller Wärmeübergang von dem Schaltungsträger auf den Wärmeableiter 14 möglich, wobei zugleich aufgrund der innigen mechanischen Verzahnung zwischen dem matrixbildenden Kunststoffgehäuse 12 und dem Wärmeableiter 14 der Entstehung von thermisch bedingten Rissen vorgebeugt wird.

Dieser Effekt wird durch die in der Längsrichtung des Steuermoduls 10, das heißt parallel zur x-Achse des Koordinatensystems 18, innerhalb der Auffächerungszone 22 wellenförmig verlaufenden Drähte 20 unterstützt. Denn temperaturbedingte Dehnungsbewegungen des Kunststoffgehäuses 12 und/oder des Schaltungsträgers können aufgrund des wellenförmigen, ondulierten Verlaufs der Drähte 20 parallel zur x-Achse kompensiert werden, wodurch die Rissentstehung aufgrund mechanischer Spannungen verhindert wird. Die näherungsweise sinusförmig gewellt verlaufenden Drähte 20 ermöglichen im Ergebnis eine "federnd"-elastische Beweglichkeit der Auffächerungszone 22 um geringe Längenbeträge parallel zur x-Achse.

Entsprechend erlauben die (vertikalen) Abstände zwischen den einzelnen Drähten 20 innerhalb der Auffächerungszone 22 parallel zur y-Achse des Koordinatensystems 18, das heißt in der Querrichtung des Steuermoduls 10, den Ausgleich geringfügiger thermischer Dehnungsbewegungen des Kunststoffgehäuses 12. Demzufolge wird auch in dieser Raumrichtung die Entstehung von mechanischen Spannungen zwischen dem Wärmeableiter 14 bzw. dem Flächengebilde 16 und dem Kunststoffgehäuse 12 aufgrund von Temperaturschwankungen verhindert und eine Rissbildung nahezu vollständig unterbunden. Im Ergebnis verfügt die Auffächerungszone 22 des Flächengebildes in den beiden Raumrichtungen parallel zur xy-Achse über eine geringfügige In-sich-Beweglichkeit bzw. Verschiebbarkeit.

Ein Vorteil des erfindungsgemäßen Steuermoduls 10 ist darin zu sehen, dass die physikalischen Eigenschaften - wie z.B. der Wärmeausdehnungskoeffizient, der Elastizitätsmodul, die Wärmeleitfähigkeit sowie der elektrische Widerstand - des Kunststoffgehäuses 12, des Flächengebildes 16 sowie des Schaltungsträgers im Hinblick auf die Vermeidung von Rissen nicht speziell aufeinander abgestimmt werden müssen, sondern vielmehr auf deren besondere technische Aufgabe ausgewählt werden können. So kann beispielsweise für das Flächengebilde 16 ein gut wärmeleitendes Metall zum Einsatz kommen, wobei dessen dann möglicherweise hoher Wärmeausdehnungskoeffizient unberücksichtigt bleiben kann. Zugleich kann der Wärmeableiter 14 zur elektromagnetischen Abschirmung gegenüber äußeren Störfeldern dienen, wenn dieser geerdet ist.

Das Flächengebilde 16 kann zur Vereinfachung des Herstellungsprozesses alternativ ein Gestrick, ein Vlies, ein Gewirk, ein Gelege oder ein Geflecht von Drähten 20 sein, das einem geflochtenen (Kupfer-)Masseanschlusskabel eines Akkumulators in einem Kraftfahrzeug entfernt ähnelt. Ferner ist es möglich, das Flächengebilde 16 durch Ausstanzen einer Vielzahl von Ausnehmungen aus einer Metallfolie oder einer kompakten Metallplatte zu bilden. Darüber hinaus ist es möglich, das Flächengebilde durch Urformen herzustellen.

Die Figur 2 zeigt eine schematische Schnittdarstellung durch das Steuermodul gemäß Figur 1 entlang der Schnittlinie II-II.

Eine Materialstärke 32 des in das Kunststoffgehäuse 12 integrierten Wärmeableiters 14 ist im Bereich der Auffächerungszone 22 deutlich kleiner als eine Materialstärke 34 in den beiden Kompaktierungszonen 24, 26 bzw. im Bereich der hier nicht mit Bezugsziffern versehenen Anschlussbündel. Dies ist dem Umstand geschuldet, dass Drähte im Bereich der Auffächerungszone 22 stark aufgefächert bzw. auseinander gezogen und bevorzugt parallel beabstandet nebeneinander angeordnet sind.

Die Figur 3 illustriert eine Draufsicht auf das Steuermodul 10 mit Presshülsen und einer Endhülse.

Auf die Anschlussbündel 28, 30 ist in einem nicht bezeichneten Durchtrittsbereich des Kunststoffgehäuses 12 des Steuermoduls 10 jeweils eine Presshülse 36, 38 unter Schaffung eines nicht bezeichneten Verdichtungsbereichs aufgepresst. Bei der Herstellung des Steuermoduls 10 wird der Wärmeableiter 14, zusammen mit dem nicht dargestellten Schaltungsträger, in ein Formwerkzeug eingelegt, in das anschließend ein Kunststoffmaterial zur Schaffung des den Schaltungsträger hermetisch dicht umschließenden Kunststoffgehäuses 12 unter erhöhtem Druck eingespritzt wird. Die vorab aufgebrachten Presshülsen 36, 38 werden im geschlossenen Formwerkzeug von zumindest bereichsweise formschlüssig ausgebildeten Ausnehmungen aufgenommen. Infolge der beiden Presshülsen 36, 38 werden die Drähte in diesem Bereich vollständig kompaktiert, so dass der Austritt von Kunststoffmaterial während des Spritzgussvorgangs verhindert wird. Anstelle der Presshülsen 36, 38 können die Drähte des Flächengebildes 16 in diesem Bereich auch miteinander gefügt, beispielsweise verlötet oder verschweißt, sein. Alternativ können die Drähte auch miteinander verklebt sein. An einem Endabschnitt 40 des Anschlussbündels 28 ist eine Endhülse 42 als Anbindungselement aufgepresst.

Diese verfügt über eine nicht bezeichnete Öffnung, die eine mechanische Anbindung des Anschlussbündels 28 an eine nicht dargestellte Wärmesenke zur Wärmeabfuhr der vom Flächengebilde 16 abgeführten Verlustwärme ermöglicht.

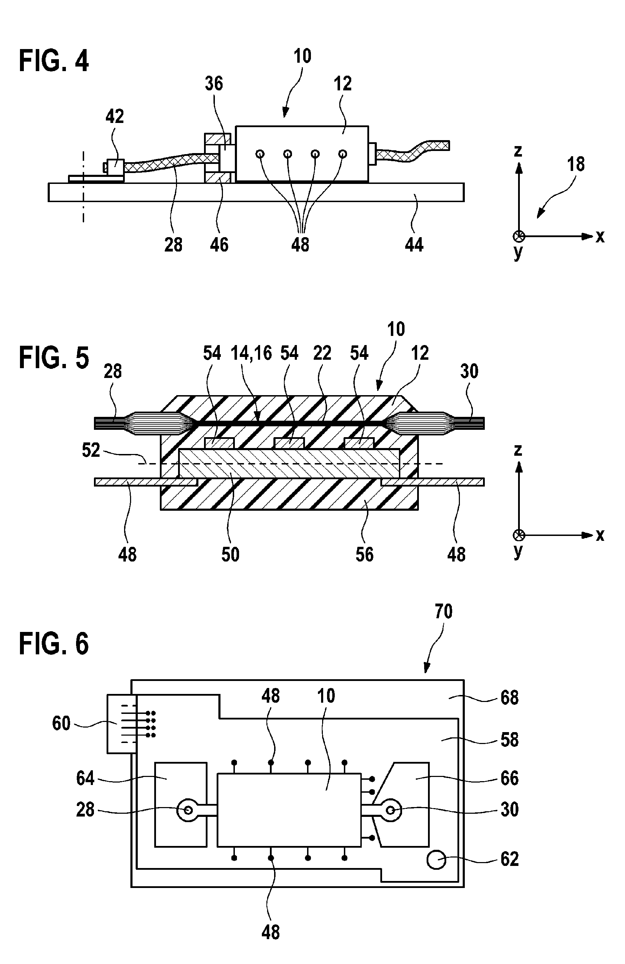

Die Figur 4 zeigt das auf einer Wärmesenke 44 montierte Steuermodul 10.

Auf einer Wärmesenke 44 ist eine Halterung 46 angeordnet, mit der die Presshülse 36 des Steuermoduls 10 zur Lagefixierung zum Beispiel verrastbar ist. Die Wärmesenke 44 kann beispielsweise ein Getriebegehäuse, ein Motorgehäuse, eine Wärmeableitfläche einer Leiterplatte oder dergleichen sein. Zur Sicherstellung einer ausreichenden Wärmeabfuhr aus dem Steuermodul 10 mittels des Wärmeableiters 14 muss eine hinreichende Temperaturdifferenz zwischen dem Steuermodul 10 und der Wärmesenke 44 bestehen. Die wärmeleitende Verbindung zwischen dem Anschlussbündel 28 und der Wärmesenke 44 erfolgt hier exemplarisch mittels der Endhülse 42, die beispielsweise als Ringöse ausgeführt ist, unter Verwendung eines hier nicht dargestellten Befestigungsmittels, wie zum Beispiel eines Gewindebolzens oder eines Nietes. An einer Außenseite des Kunststoffgehäuses 12 ist eine Vielzahl von elektrischen Anschlüssen 48 bzw. Anschlusspins vorgesehen, die zur Herstellung einer elektrischen Verbindung zwischen dem Steuermodul 10 und weiteren elektronischen, elektrischen oder elektromechanischen Komponenten dienen. Die Anschlüsse 48 sind darüber hinaus mit den auf dem Schaltungsträger des Steuermoduls 10 befindlichen elektronischen und elektrischen Komponenten elektrisch verbunden.

In der Figur 5 ist eine detailiertere Querschnittdarstellung des Steuermoduls 10 dargestellt.

Das den Wärmeableiter 14 bildende Flächengebilde 16 sowie ein Schaltungsträger 50 mit den elektrischen Anschlüssen 48 sind in das hermetisch dichte Kunststoffgehäuse 12 eingebettet bzw. eingespritzt. Auf beiden Seiten des Kunststoffgehäuses 12 ragt jeweils ein Anschlussbündel 28,30 heraus. Die Auffächerungszone 22 verläuft in einem geringen Abstand parallel zu einer Schaltungsträgerebene 52, um eine möglichst große Wärmeübergangsfläche mit einem geringen Wärmewiderstand zwischen den zu kühlenden Bauteilen 54 des Schaltungsträgers 50 und dem Flächengebilde 16 zu erreichen. Als Schaltungsträger kann beispielsweise eine Epoxidharz-Leiterplatte oder ein LTCC-Hybrid zum Einsatz kommen. Das Kunststoffgehäuse 12 ist mit einem geeigneten Kunststoffmaterial 56 gebildet, das zum einen über eine hinreichende mechanische Festigkeit und zum anderen über eine ausreichende elektrische Isolationsfähigkeit verfügt. Darüber hinaus muss das Kunststoffmaterial 56 eine ausreichend hohe Beständigkeit gegenüber chemisch aggressiven Fluiden aufweisen und bis zu einer Temperatur von 220 °C formstabil sein. Aufgrund der großflächigen Auffächerungszone 22 des Flächengebildes 16 ist eine effektive Abfuhr der von den Bauteilen 54 abgegebenen Verlustwärme über die Anschlussbündel 28, 30 gegeben.

Die Figur 6 illustriert in einer schematischen Draufsicht die Verbindung des Steuermoduls 10 mit weiteren elektrischen und elektronischen Bauteilen zu einer übergeordneten Funktionseinheit, wie zum Beispiel eine komplette Getriebesteuereinheit.

Das Steuermodul 10 ist auf einer Leiterplatte 58 ("Printed Circuit Board" PCB) oder direkt auf der Trägerplatte 68 montiert, die mit einem Stecker 60 und einem Sensor 62 als weitere Bauteile bestückt ist. Ferner verfügt die Leiterplatte 58 über zwei integrierte Wärmeaufnahmeflächen 64,66, die jeweils mit den Enden der Anschlussbündel 28, 30 des Steuermoduls 10 mechanisch fest verbunden, beispielsweise verbolzt, verlötet, verklebt oder vernietet sind, um einen effektiven Wärmeübergang zu erzielen. Die Leiterplatte 58 ist ihrerseits auf einer Trägerplatte 68, zum Beispiel mittels eines Wärmeleitklebers, befestigt. Sämtliche vorstehend genannten Komponenten stellen eine übergeordnete Funktionseinheit 70 dar, wie zum Beispiel eine vollständige Motor- oder Getriebesteuereinheit. Die elektrische Anbindung des Steuermoduls 10 an die Leiterplatte 58 der übergeordneten Funktionseinheit 70 erfolgt durch die nicht einzeln bezeichneten Anschlüsse 48.

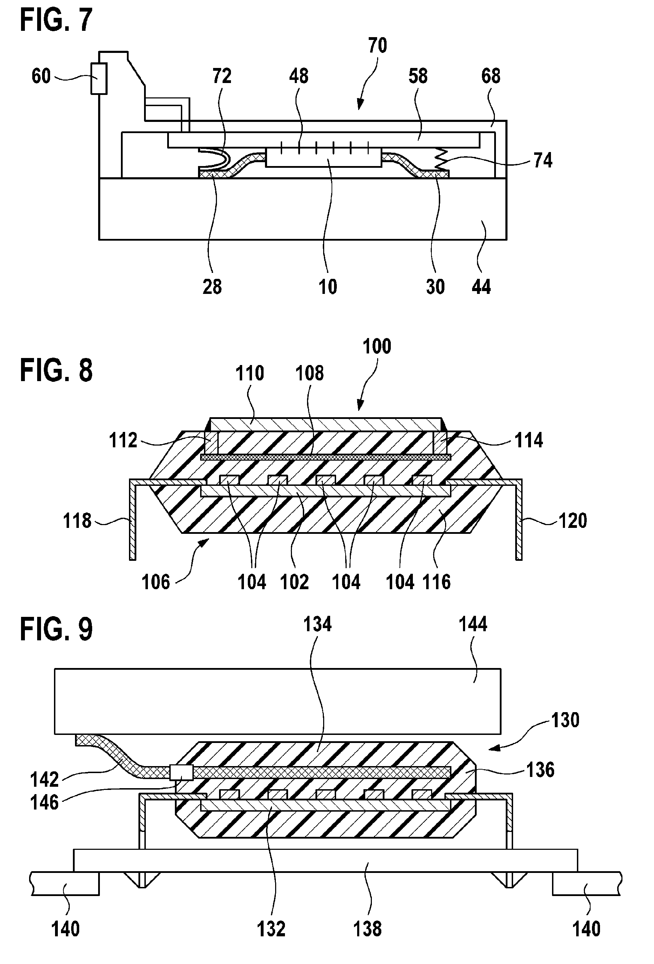

Die Figur 7 zeigt die Funktionseinheit nach Figur 6 in einer Seitenansicht, wobei die Wärmeableitung nicht über die beiden Wärmeaufnahmeflächen der Leiterplatte erfolgt, sondern über eine massive Wärmesenke.

Die Trägerplatte 68 der Funktionseinheit 70 ist auf der Wärmesenke 44, bei der es sich beispielsweise um ein Getriebegehäuse oder ein Motorgehäuse handelt, angeordnet bzw. befestigt. Der Stecker 60 ist mit der Leiterplatte 58 und den Anschlüssen 48 des Steuermoduls 10 elektrisch leitend verbunden. Die Wärmeabfuhr aus dem Steuermodul 10 erfolgt mittels der Anschlussbündel 28, 30, die durch die Federelemente 72, 74 gegen die Wärmesenke 44 gepresst werden. Das Federelement 72 ist exemplarisch als eine Blattfeder und das Federelement 74 als eine zylindrische Druckfeder ausgeführt.

Die Figur 8 veranschaulicht eine Ausführungsvariante des erfindungsgemäßen Steuermoduls mit einem innerhalb des Kunststoffgehäuses angeordneten Wärmeableiter in einer Querschnittsdarstellung.

Ein Steuermodul 100 umfasst unter anderem einen Schaltungsträger 102 mit einer Vielzahl von Bauteilen 104, der hermetisch dicht in ein Kunststoffgehäuse 106 eingekapselt ist. Oberhalb des Schaltungsträgers 102 verläuft ein Stranggebilde 108 als Wärmeableiter. Das Stranggebilde 108 ist mit einer Vielzahl von parallel zueinander verlaufenden bevorzugt metallischen Drähten gebildet. Zur Verbesserung des Zusammenhalts der Drähte können diese miteinander verseilt, verflochten oder verzwirnt sein. Für die Materialbeschaffenheit der Drähte gilt dasselbe, wie für die zur Herstellung des Flächengebildes eingesetzten Drähte, so dass an dieser Stelle auf die Ausführungen im Rahmen der Figur 1 verwiesen werden kann. Anstelle oder ergänzend zu dem Stranggebilde 108 kann auch bei dieser Ausführungsvariante ein Flächengebilde 16 als Wärmeableiter eingesetzt werden.

Auf dem Kunststoffgehäuse 106 befindet sich eine aufgeklebte oder auflaminierte Metallplatte 110 oder Metallfolie. Die zur Wärmeabfuhr vom Schaltungsträger 102 notwendige wärmeleitende Verbindung zwischen dem Stranggebilde 108 und der Metallplatte 110 ist hier mit zwei Wärmeleitbrücken 112, 114 realisiert, die im gezeigten Ausführungsbeispiel als metallische Stifte ausgeführt sind. Die Wärmeleitbrücken 112, 114 sind jeweils mit den Enden des linienhaften Stranggebildes 108 verbunden, was zum Beispiel durch Schweißen, Löten oder Kleben erfolgen kann, und schließen bevorzugt bündig mit einer nicht bezeichneten Oberseite des Kunststoffgehäuses 106 ab. Die Verbindung zwischen der Metallplatte 110 und den Wärmeleitbrücken 112, 114 erfolgt ebenfalls durch Schweißen, Löten, Nieten oder Kleben. Werden die Wärmeleitbrücken 112, 114 beim Spritzgussvorgang ("Molding") des Kunststoffgehäuses 106 vom Kunststoffmaterial 116 ("Moldmasse") bedeckt, müssen diese vor der Kontaktierung mit der Metallplatte 110 frei geschliffen werden. Ein Hauptvorteil dieser Ausführungsform gegenüber der Variante nach Maßgabe der Figur 1 bis 6 liegt darin, dass keine flexiblen Anschlussbündel aus dem Kunststoffgehäuse 106 herausgeführt werden müssen. Die elektrische Anbindung des Steuermoduls 100 an weitere, hier nicht dargestellte elektrische oder elektronische Bauteile erfolgt mittels der Anschlüsse 118, 120.

Die Figur 9 betrifft eine weitere Ausführungsform eines Steuermoduls, bei der ein Stranggebilde aus dem Kunststoffgehäuse einseitig herausgeführt ist.

Ein Steuermodul 130 umfasst unter anderem einen Schaltungsträger 132 mit einer Vielzahl nicht bezeichneter Bauteile und ein parallel hierzu beabstandet positioniertes Stranggebilde 134 als Wärmeableiter, die hermetisch dicht von einem Kunststoffgehäuse 136 umschlossen sind. Das Steuermodul 130 ist über nicht bezeichnete Anschlüsse und Lötstellen elektrisch mit einer Leiterplatte 138 verbunden, die wiederum auf einer Trägerplatte 140 befestigt ist. Das Steuermodul 130, die Leiterplatte 138 sowie die Trägerplatte 140 sind Teil einer nicht dargestellten, übergeordneten Funktionseinheit. Ein Anschlussbündel 142 des Stranggebildes 134 ist fest mit einer Wärmesenke 144 verbunden, um eine Wärmeableitung zu gewährleisten. Das Stranggebilde 134 verfügt über eine Kompaktierungszone 146, die entsprechend zu den im Rahmen der Figuren 1 und 2 bereits beschriebenen Kompaktierungszonen ausgestaltet ist.

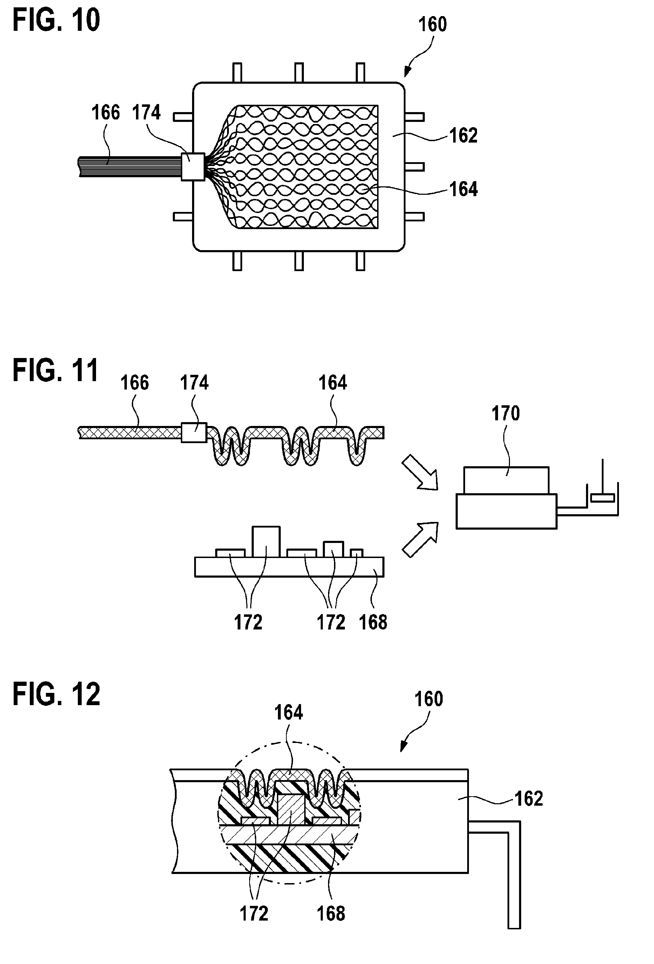

Die Figuren 10 bis 12, auf die im weiteren Fortgang der Beschreibung zugleich Bezug genommen wird, illustrieren eine weitere Ausführungsform eines Steuermoduls mit einem vorgeformten Flächengebilde als Wärmeableiter.

Ein Steuermodul 160 mit einem ("gemoldeten") Kunststoffgehäuse 162 und einer Vielzahl nicht bezeichneter elektrischer Anschlüsse weist oberseitig ein Flächengebilde 164 mit einem einseitigen Anschlussbündel 166 zur Anbindung des wärmeableitenden Flächengebildes 164 an eine nicht dargestellte Wärmesenke auf.

Die Figur 11 zeigt in einer vereinfachten Darstellung den Herstellungsverlauf des Steuermoduls 160. Das Flächengebilde 164 wird zusammen mit einem Schaltungsträger 168 in ein geeignetes Formwerkzeug 170 eingebracht, in das zur Herstellung des Kunststoffgehäuses 162 ein Kunststoffmaterial unter hohem Druck eingespritzt wird. Im Unterschied zur bereits erläuterten, ebenen Ausführungsform des Flächengebildes 16, folgt eine Oberflächentopografie des Flächengebildes 164 hier näherungsweise der Oberflächentopografie des Schaltungsträgers 168 mit den darauf befindlichen Bauteilen 172. Dies wird durch entsprechendes Vor- bzw. Umformen des anfänglich noch ebenen Flächengebildes 164 in einem dem Molding-Verfahren vorgelagerten, separaten Arbeitsschritt erreicht. Im Übrigen folgt der Aufbau des Flächengebildes 164, mit einer Vielzahl von bevorzugt metallischen Drähten, dem weiter oben bereits beschriebenen Aufbau des Flächengebildes 16.

Die Figur 12 veranschaulicht eine vergrößerte Darstellung des Steuermoduls 160. Die dreidimensionale Oberflächengeometrie des Flächengebildes 164 korrespondiert im

Wesentlichen mit der dreidimensionalen Oberflächengeometrie der Bauteile 172 auf dem Schaltungsträger 168. Wie aus der Figur 12 ersichtlich ist, besteht somit ein wärmeleitungstechnisch bzw. räumlich inniger Kontakt zwischen dem Flächengebilde 164 und den Bauteilen 172, wodurch sich eine effektivere Wärmeableitung vom Schaltungsträger 168 hinein in das Flächengebilde 164 ergibt. Darüber hinaus kann das Flächengebilde 164 direkt an temperaturkritische Bereiche des Schaltungsträgers 168 herangeführt werden und es wird zugleich weniger Kunststoffmaterial zur Herstellung des Kunststoffgehäuses 162 benötigt. Darüber hinaus wird die Oberfläche des Flächengebildes 164 infolge der dreidimensionalen Oberflächengeometrie vergrößert, wodurch insbesondere die Wärmeabgabe durch (Wärme-) Strahlung und Konvektion verbessert wird.

In dem Bereich, wo das Flächengebilde 164 aus dem Kunststoffgehäuse 162 austritt, ist ein Verdichtungsbereich 174 vorgesehen, in dem die das Flächengebilde 164 bildenden metallischen Drähte weitgehend zwischenraumfrei bzw. kompakt aneinander liegen, wodurch ein Austreten des Kunststoffmaterials während des Molding-Prozesses aus dem Formwerkzug 170 in diesem Bereich verhindert wird. Der Verdichtungsbereich 174 kann beispielsweise mit einer Presshülse oder mittels einer Fügestelle, beispielsweise mittels einer Löt-, Schweiß- oder Klebestelle geschaffen werden. Das Flächengebilde 164 ist nach dem Abschluss des Moldingprozesses im Formwerkzeug 170 zumindest bereichsweise vom Kunststoffmaterial des Kunststoffgehäuses 162 durchsetzt bzw. von diesem infiltriert.

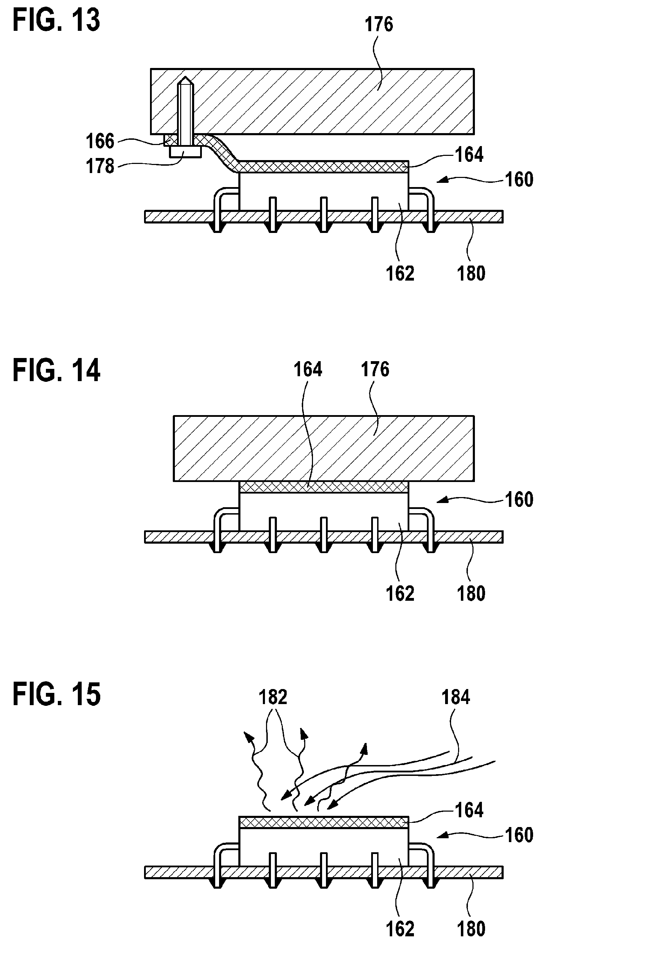

Die Figuren 13 bis 15 veranschaulichen drei Optionen einer thermischen Anbindung des Steuermoduls 160 nach Maßgabe der Figuren 10 bis 12 an eine massive Wärmesenke. Nach Maßgabe der Figur 13 erfolgt die wärmetechnische Anbindung des Steuermoduls 160 an eine Wärmesenke 176 durch das Anschlussbündel 166 des vorgeformten Flächengebildes 164, das mittels eines Befestigungsbolzens 178 mit der Wärmesenke 176 fest verbunden ist. Bei der Wärmesenke 176 handelt es sich beispielsweise um ein metallisches Getriebegehäuse oder ein Motorgehäuse. Das Steuermodul 160 ist mittels nicht bezeichneter Anschlüsse mit einer Leiterplatte 180, zum Beispiel durch Lötstellen, elektrisch leitend verbunden. Die Wärmeableitung aus dem Steuermodul 160 erfolgt hier vorrangig durch Wärmeleitung über das Anschlussbündel 166 und darüber hinaus, da kein unmittelbarer Kontakt zwischen der Wärmesenke 176 und dem Flächengebilde 164 besteht, subsidiär durch (Wärme-)Strahlung und/oder Konvektion. Demzufolge ist es bei dieser Ausführungsform unschädlich, wenn das Flächengebilde 164 vollständig von dem das Kunststoffgehäuse 162 bildenden Material durchsetzt ist.

Bei der Ausführungsvariante nach Maßgabe der Figur 14 befindet sich das eine dreidimensionale Oberflächengeometrie aufweisende Flächengebilde 164 unmittelbar zwischen der Wärmesenke 176 und dem Kunststoffgehäuse 162 des Steuermoduls 160 und es ist kein Anschlussbündel vorhanden. Zur Erzielung eines möglichst geringen Wärmeübergangswiderstandes zwischen dem Steuermodul 160 und der Wärmesenke 176 sollte das Flächengebilde 164 nicht vollständig vom Kunststoffmaterial durchsetzt sein, das heißt die das Flächengebilde 164 bildenden metallischen Drähte liegen im Bereich einer nicht bezeichneten Oberseite des Flächengebildes 164 frei. Hierdurch können sich die oberflächennahen Bereiche des Flächengebildes 164 bzw. die freiliegenden Drähte, aufgrund der hierdurch gegebenen geringfügigen Verformbarkeit, geometrisch leichter an eine Gegenfläche, zum Beispiel in Gestalt einer nicht bezeichneten Unterseite der Wärmesenke 176 anpassen. Der Wärmeübergang zwischen dem Steuermodul 160 und der Wärmesenke 176 erfolgt in dieser Konstellation nahezu ausschließlich durch Wärmeleitung.

Im Fall der Ausführungsvariante nach Figur 15 erfolgt die Wärmeableitung aus dem Steuermodul 160 mittels des Flächengebildes 164 durch (Wärme-)Strahlung 182 in Verbindung mit Konvektion durch ein anströmendes Fluid 184. Auch in dieser Konstellation sollte das den Wärmeableiter bildende Flächengebilde 164 zur Erzielung einer möglichst effektiven Wärmeableitung aus dem Steuermodul 160 oberseitig nicht vollständig vom Kunststoffmaterial des Kunststoffgehäuses 162 durchdrungen sein.

## Patentansprüche

1. Steuermodul (10, 100, 130, 160), insbesondere Getriebe- oder Motorsteuermodul für ein Kraftfahrzeug, mit einem eine Vielzahl elektronische und/oder elektrische Bauteile (54, 172) aufweisenden Schaltungsträger (50, 102, 132, 168), wobei der Schaltungsträger (50, 102, 132, 168) allseitig von einem Kunststoffmaterial (56, 116) umgeben ist, das ein Kunststoffgehäuse (12, 106, 136,162) bildet, und das Kunststoffgehäuse (12, 106, 136, 162) eine Vielzahl von Anschlüssen (48, 118, 120) aufweist, die mit den Bauteilen (54, 172) elektrisch verbunden sind, **dadurch gekennzeichnet, dass** das Kunststoffgehäuse (12, 106, 136, 162) zur Wärmeableitung vom Schaltungsträger (50, 102, 132, 168) über mindestens einen Wärmeableiter (14) verfügt, der zumindest bereichsweise von dem Kunststoffmaterial (56, 116) durchsetzt ist und der im Wesentlichen parallel zum Schaltungsträger (50, 102, 132, 168) verläuft.

2. Steuermodul (10, 100, 130, 160) nach Anspruch 1, wobei der mindestens eine Wärmeableiter (14) ein Flächengebilde (16, 164) ist, das eine Vielzahl insbesondere metallischer Drähte (20) enthält.

3. Steuermodul (100, 130) nach Anspruch 1, wobei der mindestens eine Wärmeableiter (14) ein Stranggebilde (108, 134) ist, das mit einer Vielzahl insbesondere metallischer Drähte gebildet ist, die verwickelt, verdrillt, verflochten und/oder verzwirnt sind.

4. Steuermodul (10, 100, 130, 160) nach Anspruch 2 oder 3, **dadurch gekennzeichnet, dass** der Wärmeableiter (14) als Flächengebilde (16, 164) oder als Stranggebilde (108, 134), insbesondere als Geflecht ausgeführt ist.

5. Steuermodul (10, 160) nach Anspruch 1 oder 2, wobei das Flächengebilde (16, 164) eine im Wesentlichen innerhalb des Kunststoffgehäuses (12, 162) befindliche Auffächerungszone (22) und mindestens eine sich daran anschließende Kompaktierungszone (24, 26) zur wärmeleitenden Anbindung des Wärmeableiters (14) an eine Wärmesenke (44) aufweist, wobei die mindestens eine Kompaktierungszone (24, 26) im Wesentlichen außerhalb des Kunststoffgehäuses (12, 162) verläuft.

6. Steuermodul (10, 160) nach Anspruch 5, wobei die Auffächerungszone (22) des Wärmeableiters (14) im Wesentlichen parallel zum Schaltungsträger (50, 168) in mindestens einer Raumrichtung geringfügig in sich beweglich ausgebildet ist.

7. Steuermodul (10, 160) nach Anspruch 5 oder 6, wobei im Bereich der mindestens einen Kompaktierungszone (24, 26) mindestens ein Presselement, insbesondere mindestens eine Presshülse (36, 38), und/oder mindestens eine Fügestelle, insbesondere eine Lötstelle oder eine Klebestelle, vorhanden ist.

8. Steuermodul (10, 160) nach Anspruch 7, wobei die mindestens eine Kompaktierungszone (24, 26) in einem Endabschnitt (40) mit mindestens einem Anbindungselement, insbesondere mit einer ringförmigen Endhülse (42), versehen ist.

9. Steuermodul (10, 160) nach einem der Ansprüche 5 bis 8, wobei das Flächengebilde (16, 164) eine Oberflächengeometrie aufweist, die im Wesentlichen einer Oberflächengeometrie des Schaltungsträgers (50, 168) mit den darauf befindlichen Bauteilen (54, 172) folgt.

10. Steuermodul (10, 160) nach einem der Ansprüche 1 bis 3, wobei eine Metallplatte (110) und/oder eine Metallfolie auf dem Kunststoffgehäuse (106) befestigt, insbesondere auf dieses aufgeklebt oder auflaminiert ist, und das Flächengebilde (16, 164) und/oder das Stranggebilde (108, 134) mit der Metallplatte (110) oder der Metallfolie durch mindestens eine Wärmeleitbrücke (112, 114), insbesondere mittels mindestens eines metallischen Stiftes, wärmeleitend verbunden ist.
